# EUROPÄISCHE PATENTSCHRIFT

(11) **EP 2 907 149 B1**
(45) Veröffentlichungstag und Bekanntmachung des Hinweises auf die Patenterteilung: **14.06.2017**
(21) Anmeldenummer: 13773803.5
(22) Anmeldetag: 09.10.2013
(51) Int. Cl.: H01H 9/16, H02J 13/00, H03K 17/18, H01H 3/02

(54) **SYSTEM ZUR FUNKTIONSÜBERWACHUNG EINER STROMSCHLEIFE**
SYSTEM FOR MONITORING THE OPERATION OF A CURRENT LOOP
SYSTÈME DE SURVEILLANCE DU FONCTIONNEMENT D'UNE BOUCLE DE COURANT

(30) Priorität: 10.10.2012 DE 102012218429
(43) Veröffentlichungstag der Anmeldung: 19.08.2015
(73) Patentinhaber: Zumtobel Lighting GmbH, 32657 Lemgo (DE)
(72) Erfinder: WITTMANN, Gerhard, 81249 München (DE)
(74) Vertreter: Thun, Clemens
(86) Internationale Anmeldenummer: PCT/EP2013/071019
(87) Internationale Veröffentlichungsnummer: WO 2014/056967

(56) Entgegenhaltungen:
- EP-A1- 1 137 024
- DE-A1- 4 221 916
- US-A1- 2004 189 481
- US-B2- 6 646 362

## Beschreibung

Die vorliegende Erfindung betrifft ein System zum Überwachen der Funktion einer Stromschleife. Stromschleifen im Sinne der vorliegenden Erfindung werden gemäß dem Stand der Technik dazu genutzt, den Zustand eines in der Schleife befindlichen Schalters zu erkennen. In einem Normalbetrieb ist die entsprechend der üblichen Zweidraht-Installationstechnik ausgebildete Schleife gespeist durch eine Stromquelle von dem Strom durchflossen. Der Stromfluss wird durch eine entsprechend ausgeführte Auswerteeinheit detektiert. Sobald der Stromfluss z.B. durch ein Betätigen des Unterbrechungsschalters unterbrochen wird, wird diese Unterbrechung des Stromflusses erkannt. Mit Hilfe einer derartigen Stromschleife wird beispielweise entsprechen den Vorschriften in Italien ein sog. NOTAUS-Schalter realisiert, der von der Feuerwehr bedient werden und gezielt dazu genutzt werden kann, die Notbeleuchtung zu deaktivieren. Auch das Testen der Funktion von Busphasenwächtern, die zur Überwachung der allgemeinen Stromversorgung eingesetzt werden und einen Stromausfall an eine Notbeleuchtungsanlage melden, erfolgt mit Hilfe derartiger Stromschleifen.

Nachteilig an der oben beschriebenen bekannten Lösung ist, dass Störungen der Übertragung des dauerhaft fließenden Gleichstroms zu einem fehlerhaften Interpretieren des Schalterzustands führen können. So kann z.B. ein Anbohren der in einer Wand verlaufenden Leitung die Stromschleife unterbrechen und so eine unbeabsichtigte Abschaltung der Notbeleuchtung auslösen. In gleicher Weise würde auch ein Kurzschluss dazu führen, dass der Zustand des Schalters nicht zuverlässig und richtig erkannt wird.

Aus der Netzwerktechnik ist darüber hinaus die Nutzung so genannter Herzschlag-Signale bekannt. Dabei wird bei Nutzung eines Bus-Systems regelmäßig von jedem angeschlossenen Gerät eine bestimmte Signalisierungsabfolge über den Bus gesendet um die weiterhin bestehende Erreichbarkeit des jeweiligen Geräts sicherzustellen. Ein solches System wird von dem US Patent US 7,590,898 B2 gezeigt. Eine solche Signalisierung ist jedoch sehr aufwendig, da ein Bussystem und ein aufwendiges Nachrichtenformat Voraussetzung hierfür sind.

Die EP 1 137 024 A1) beschreibt die Auswertung einer codierten Schalterstellung. Dabei wird ein Codierer mit einer Hilfsspannung versorgt, welche abhängig vom Schalterzustand variiert. Dieses Signal wird über einen Optokoppler an den Decodierer übertragen. Die Übertragung über die Übertragungsstrecke zwischen dem Codierer und dem Decodierer geschieht also ausschließlich über Licht.

Die DE 42 21 916 A1 zeigt eine Schaltungsanordnung zur Überwachung des Schaltzustandes eines in einem Laststromkreis angeordneten Schalters. Eine parallele Gleichspannungsquelle G und Wechselspanungsquelle W sind über einen Schalter S mit einem Transformator verbunden. Parallel zu dem Schalter S sind eine Kapazität und ein Widerstand seriell geschaltet. Somit bildet sich ein Schwingkreis bestehend aus der Primärspule des Transformators, der Kapazität und dem Widerstand, wobei die Kapazität und der Widerstand durch den Schalter S zu-/abschaltbar sind. Hierdurch ändert sich die abgegriffene Wechselspannung auf der Sekundärseite des Transformators abhängig von dem Schalter S. Aus dieser sekundärseitigen Wechselspannung wird ein Ausgangssignal über einen Signalumsetzer SU an eine Übertragungsleitung ÜL ausgegeben.

Die US 6,646,362 B2 zeigt einen Schaltkreis, um eine Zustandsinformation zu übertragen.

Die US 2004/0189481 A1 zeigt eine Schaltung, um den Zustand eines Schalters zu detektieren.

Der Erfindung liegt die Aufgabe zu Grunde, eine verbesserte Lösung zur Realisierung einer funktionsüberwachten Stromschleife anzugeben, welche bei geringem Aufwand eine zuverlässige Unterscheidung der Zustände des in der Stromschleife befindlichen Schaltelements ermöglicht.

Die Aufgabe wird erfindungsgemäß durch ein System gemäß Anspruch 1 gelöst. Vorteilhafte Weiterbildungen der Erfindung sind Gegenstand der hierauf rückbezogenen Unteransprüche.

Auch bei dem erfindungsgemäßen System wird eine Stromschleife von einer Stromquelle gespeist und weist ein Schaltelement auf, wobei am Ausgang der Stromschleife eine Bewertungseinheit angeordnet ist, welche dazu ausgebildet ist, auf Basis des in der Stromschleife fließenden Stroms einen Schaltzustand des Schaltelements zu erkennen. Erfindungsgemäß ist nunmehr in der Stromschleife weiterhin eine Signalerzeugungseinrichtung angeordnet ist, welche mit dem Schalter verbunden und dazu ausgebildet ist, in der Stromschleife ein den Schaltzustand des Schaltelements kennzeichnendes dynamisches Signal zu generieren, wobei das Signal als ein gepulstes Signal durch Kurzschließen des Schleifenstroms generiert wird.

Gemäß der erfindungsgemäßen Lösung ist also vorgesehen, dass durch ein zusätzliches Element der Zustand des Schaltelements in ein dynamisches Signal umgesetzt wird, welches wiederum von der Auswerteeinheit bewertet wird, allerdings deutlich zuverlässiger Auskunft über den Zustand des Schaltelements gibt und es insbesondere auch ermöglicht, Fehler in der Funktion der Stromschleife zu erkennen. Dabei ist das von der Signalerzeugungseinrichtung generierte Signal ein gepulstes Signal, welches erfindungsgemäß dadurch erzeugt wird, dass die Signalerzeugungseinrichtung den Schleifenstroms vorübergehend kurzschließt. Die Signalerzeugungseinrichtung kann dann dazu ausgebildet sein, anhand der Frequenz und/oder Phase und/oder Amplitude und/oder anhand des Tastverhältnisses des Signals den Zustand des Schaltelements zu kennzeichnen. Dabei kann das Schaltelement auch ein Mehrfachschalter sein und die Signalerzeugungseinrichtung dazu ausgebildet sein, jeden einzelnen der Schalterzustände durch Modifizieren des Signals zu charakterisieren.

Ein Vorteil der erfindungsgemäßen Lösung besteht insbesondere auch darin, dass weitestgehend auf bestehende Komponenten einer Stromschleife zurückgegriffen werden kann und lediglich das Nachrüsten der Signalerzeugungseinrichtung erforderlich ist. Diese ist vorzugsweise in unmittelbarer Nähe des Schaltelements angeordnet oder bildet eine Einheit mit dem Schaltelement.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: eine Stromschleife gemäß dem Stand der Technik; und
- Fig. 2: ein Ausführungsbeispiel einer erfindungsgemäßen Stromschleife.

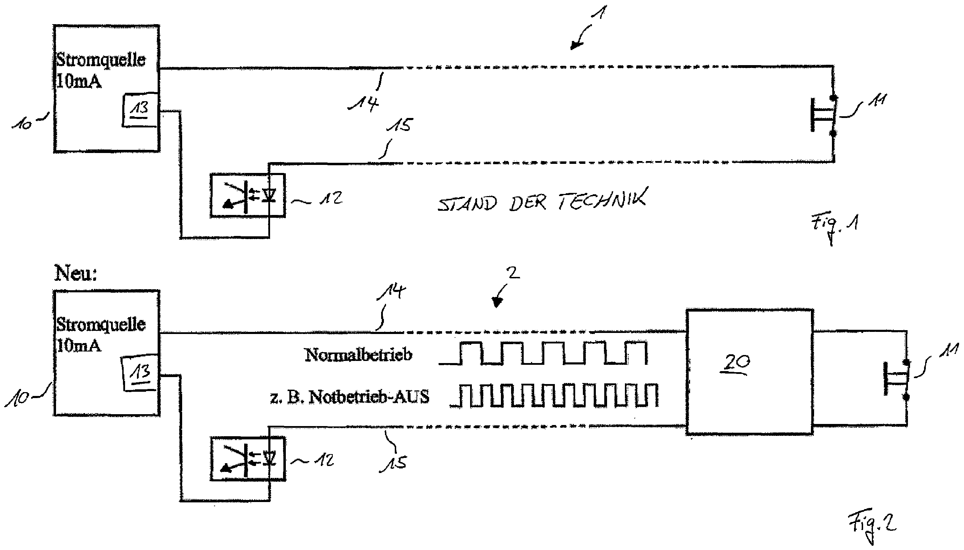

Zunächst wird anhand von Fig. 1 die der Erfindung zu Grunde liegende Problematik anhand einer exemplarischen Stromschleife erläutert. Anschließend wird mittels Fig. 2 der Aufbau und die Funktionsweise eines Ausführungsbeispiels der erfindungsgemäßen Lösung gezeigt.

Fig. 1 zeigt ein exemplarisches NOTAUS-Schaltersystem 1. Es beinhaltet eine Stromquelle 10, einen Schalter 11, einen Optokoppler 12 sowie eine Bewertungseinheit 13, welche im vorliegenden Fall in die Stromquelle 10 integriert ist. Die Stromquelle 10 ist dabei über eine erste Leitung 14 mit dem Schalter 11 verbunden. Der Schalter 11 ist über eine zweite Leitung 15 mit dem Optokoppler 12 verbunden, dessen Ausgang mit der Stromquelle 10 und insbesondere mit der Bewertungseinheit 13 verbunden ist.

Die Stromquelle 10 prägt einen Gleichstrom in die Leitung 14 ein. Der Gleichstrom fließt durch den Schalter 11 und die Leitung 15 zu dem Optokoppler 12 und von dort zurück zu der Stromquelle 10 und der Bewertungseinheit 13. Je nachdem ob der Schalter 11 geöffnet oder geschlossen ist, wird ein dauerhafter Stromfluss durch die Schleife ermöglicht oder unterbrochen. Dies führt je nach Schalterzustand zu einem statischen High- oder Low-Signal am Ausgang des Optokopplers 12, welches von der Bewertungseinheit 13 erfasst wird, die davon abhängig einen Zustand des Schalters 11 erkennt. Beispielsweise kann dann durch Betätigen des Schalters 11 im Rahmen eines sog. Fernaus gezielt die Notbeleuchtung deaktiviert werden.

Neben dem Betätigen des Schalters 11 können jedoch eine Vielzahl weiterer Einflüsse den Stromfluss durch die Schleife unterbrechen und zu einer fehlerhaften Interpretation des Schalterzustands führen. So könnte z.B. eine Beschädigung einer der Leitungen 14, 15 zu einer Unterbrechung des Stromflusses führen. Dies ist nachteilig, da so unbeabsichtigt bestimmte Funktionen ausgelöst werden. In gleicher Weise kann auch ein Kurzschluss der Schleife vorliegen, der wiederum zu einem falschen, d.h. nicht den Zustand des Schalters 11 repräsentierenden Signal am Ausgang des Optokopplers 12 führt.

In Fig. 2 ist ein exemplarisches Ausführungsbeispiel einer erfindungsgemäßen Stromschleife 2 gezeigt. Wiederum ist eine Stromquelle 10 vorgesehen, welche die Stromschleife - mit einem Gleichstrom von beispielsweise 10mA - speist und eine Auswerteeinheit 13 aufweist, welche das Ausgangssignal des Optokopplers 12 erfasst und bewertet. In dieser Hinsicht ist die erfindungsgemäße Lösung also gleich zu der Stromschleife gemäß dem Stand der Technik und es können die bereits vorhandenen Elemente und Einheiten weiterhin genutzt werden.

Zusätzlich ist nunmehr allerdings in der Stromschleife eine Signalerzeugungseinrichtung 20 direkt bei dem oder zumindest in der Nähe des Schalters 11 angeordnet. Beide Elemente können auch eine Einheit bilden. In dem hier dargestellten Ausführungsbeispiel ist der Schalter 11 als Unterbrechungsschalter ausgeführt. Er könnte jedoch ebenfalls als Taster oder als gewöhnlicher Schalter, insbesondere auch als Mehrfachschalter ausgeführt sein. Die Signalerzeugungseinrichtung 20 ist dabei mit beiden Polen des Schalters 11 verbunden. Zusätzlich ist sie mit den beiden Leitungen 14, 15 verbunden und über diese mit der Stromquelle 10 bzw. dem Optokoppler 12 verbunden.

Die Stromquelle 10 speist die Schleife wiederum mit Strom, der über die Leitung 14 an die Signalerzeugungseinrichtung 20 übermittelt wird. Diese erkennt nunmehr den Schaltzustand des Schalters 11 und generiert aus dem Schleifenstrom ein den Schaltzustand des Schalters kennzeichnendes dynamisches Signal. Die zur Erzeugung dieses Signals notwendige Energie bezieht die Signalerzeugungseinrichtung 20 dabei bevorzugt lediglich aus dem Strom der Stromschleife. Alternativ kann die Signalerzeugungseinrichtung 20 auch über eine zusätzliche Energieversorgung verfügen, welche jedoch nicht dargestellt ist.

Die Signalerzeugungseinrichtung 20 erzeugt das Signal beispielsweise, indem sie die Stromschleife in einem definierten Rhythmus kurzschließt, wobei die Frequenz und/oder das Tastverhältnis vom Zustand des Schalters 11 abhängig ist. Z.B. könnte bei einem Normalbetrieb ein Signal mit einer Frequenz von 32 Hz erzeugt werden, während hingegen bei Betätigen des Schalters die Frequenz signifikant erhöht, z.B. verdoppelt wird. In gleicher oder ergänzender Weise könnte auch das Tastverhältnis abhängig vom Zustand des Schalters geändert werden.

Das hieraus resultierende Signal am Ausgang des Optokopplers 12 kann dann von der Auswerteeinheit 13 erfasst und bewertet werden, so dass diese sehr einfach den Zustand des Schalters 11 erkennen kann.

Zusätzlich kann die Auswerteeinheit 13 auch erkennen, ob eine Störung der Stromschleife vorliegt. Dies könnte der Fall sein, wenn eine der Leitungen 14, 15 beschädigt, also unterbrochen ist oder ein Kurschluss vorliegt. In diesem Fall liegt am Ausgang des Optokopplers wiederum ein statisches Signal vor, welches eindeutig nicht auf die Aktivität der Signalerzeugungseinrichtung 20 zurückzuführen ist und dementsprechend signalisiert, das die zuverlässige Funktion der Stromschleife nicht gewährleistet ist.

Dabei kann der Schalter 11 bzw. das Schaltelement auch derart ausgebildet sein, dass es mehr als lediglich zwei Zustände einnehmen kann. Auch in diesem Fall ist vorgesehen, dass jeder der möglichen Schaltzustände durch die Signalerzeugungseinrichtung erkannt wird und ein entsprechendes Signal in der Stromschleife generiert wird. Ein Modifizieren des Stroms der Schleife erfolgt dann also mit unterschiedlichen Frequenzen bzw. Tastverhältnissen, welche jeweils die Schalterzustände charakterisieren.

Ein wesentlicher Vorteil der erfindungsgemäßen Lösung besteht dabei darin, dass weitestgehend auf die bereits vorhandenen Einheiten zurückgegriffen werden kann und lediglich die Stromschleife mit der Signalerzeugungseinrichtung nachgerüstet werden muss. Es ist lediglich eine Anpassung der Auswerteeinheit dahingehend vorzunehmen, dass diese nunmehr auch die Dynamik des eintreffenden Signals bewertet, was allerdings in der Regel sehr einfach softwaremäßig erfolgen kann. Der Aufwand zum Optimieren des gesamten Systems ist dementsprechend äußerst gering.

## Patentansprüche

1. System zur Überwachung der Funktion einer Stromschleife (2), welche von einer Stromquelle (10) gespeist wird und ein Schaltelement (11) aufweist, wobei am Ausgang der Stromschleife (2) eine Bewertungseinheit (13) angeordnet ist, welche dazu ausgebildet ist, auf Basis des in der Stromschleife (2) fließenden Stroms einen Zustand des Schaltelements (11) zu erkennen,
wobei in der Stromschleife (2) weiterhin eine Signalerzeugungseinrichtung (20) angeordnet ist, welche mit dem Schaltelement (11) verbunden und dazu ausgebildet ist, in der Stromschleife (2) ein den Zustand des Schaltelements (11) kennzeichnendes dynamisches Signal zu generieren,
**dadurch gekennzeichnet,**
**dass** die Signalerzeugungseinrichtung (20) dazu ausgebildet ist, das Signal als ein gepulstes Signal durch Kurzschließen des Schleifenstroms zu generieren.

2. System nach Anspruch 1,
**dadurch gekennzeichnet,**
**dass** die Signalerzeugungseinrichtung (20) dazu ausgebildet ist, anhand der Frequenz und/oder Phase und/oder Amplitude und/oder anhand des Tastverhältnisses des Signals den Zustand des Schaltelements (11) zu kennzeichnen.

3. System nach Anspruch 1 oder 2,
**dadurch gekennzeichnet,**
**dass** die Bewertungseinheit (13) ausgebildet ist, um anhand der Frequenz und/oder Phase und/oder Amplitude und/oder anhand des Tastverhältnisses des Signals eine Unterbrechung der Stromschleife (2), einen Kurschluss oder einen Störungsbetrieb zu erkennen.

4. System nach einem der vorherigen Ansprüche,
**dadurch gekennzeichnet,**
**dass** die Signalerzeugungseinrichtung (20) in unmittelbarer Nähe des Schaltelements (11) angeordnet ist oder eine Einheit mit dem Schaltelement (11) bildet.

5. System nach einem der vorherigen Ansprüche,
**dadurch gekennzeichnet,**
**dass** das Schaltelement (11) ein Mehrfachschalter ist und die Signalerzeugungseinrichtung (20) dazu ausgebildet ist, jeden einzelnen der Schalterzustände durch Modifizieren des Signals zu charakterisieren.

## Claims

1. A system for monitoring the functioning of a current loop (2), which is fed by a current source (10) and has a switching element (11), wherein an evaluation unit (13) is arranged at the output of the current loop (2), which evaluation unit is designed to identify a state of the switching element (11) on the basis of the current flowing in the current loop (2),
wherein, furthermore, a signal generation device (20) is arranged in the current loop (2), which signal generation device is connected to the switching element (11) and is designed to generate a dynamic signal characterizing the state of the switching element (11) in the current loop (2),
**characterized in**
**that** the signal generation device (20) is designed to generate the signal as a pulsed signal by short-circuiting the loop current.

2. A system according to Claim 1,
**characterized in**
**that** the signal generation device (20) is designed to characterize the state of the switching element (11) by means of the frequency and/or phase and/or amplitude and/or by means of the duty cycle of the signal.

3. A system according to Claim 1 or 2,
**characterized in**
**that** the evaluation unit (13) is designed in order to identify an interruption of the current loop (2), a short circuit or a malfunction by means of the frequency and/or phase and/or amplitude and/or by means of the duty cycle of the signal.

4. A system according to any one of the preceding claims,
**characterized in**
**that** the signal generation device (20) is arranged in the immediate vicinity of the switching element (11) or forms a unit with the switching element (11).

5. A system according to any one of the preceding claims,
**characterized in**
**that** the switching element (11) is a multiple switch and the signal generation device (20) is designed to characterize each one of the switching states by modification of the signal.

## Revendications

1. Système pour la surveillance du fonctionnement d'une boucle de courant (2) qui est alimentée par une source de courant (10) et qui comprend un élément de commutation (11), moyennant quoi, à la sortie de la boucle de courant (2), une unité d'analyse (13) est disposée, qui est conçue pour détecter, sur la base du courant s'écoulant dans la boucle de courant (2), un état de l'élément de commutation (11),
moyennant quoi, dans la boucle de courant (2), se trouve en outre un dispositif de génération de signaux (20) qui est relié avec l'élément de commutation (11) et qui est conçu pour générer, dans la boucle de courant (2), un signal dynamique caractérisant l'état de l'élément de commutation (11),
**caractérisé en ce que**
le dispositif de génération de signaux (20) est conçu pour générer le signal sous la forme d'un signal pulsé par court-circuitage de la boucle de courant.

2. Système selon la revendication 1,
**caractérisé en ce que**
le dispositif de génération de signaux (20) est conçu pour caractériser, à l'aide de la fréquence et/ou de la phase et/ou de l'amplitude et/ou à l'aide du rapport cyclique du signal, l'état de l'élément de commutation (11).

3. Système selon la revendication 1 ou 2,
**caractérisé en ce que**
l'unité d'analyse (13) est conçue pour détecter, à l'aide de la fréquence et/ou de la phase et/ou de l'amplitude et/ou à l'aide du rapport cyclique du signal, une interruption de la boucle de courant (2), un court-circuit ou un fonctionnement de perturbation.

4. Système selon l'une des revendications précédentes,
**caractérisé en ce que**
le dispositif de génération de signaux (20) est disposé à proximité immédiate de l'élément de commutation (11) ou constitue une unité avec l'élément de commutation (11).

5. Système selon l'une des revendications précédentes,
**caractérisé en ce que**
l'élément de commutation (11) est un commutateur multiple et le dispositif de génération de signaux (20) est conçu pour caractériser chacun des états du commutateur par la modification du signal.
